# FASCICULE DE BREVET EUROPEEN

(11) **EP 0 674 382 B1**
(45) Date de publication et mention de la délivrance du brevet: **29.07.1998**
(21) Numéro de dépôt: 95104050.0
(22) Date de dépôt: 20.03.1995
(51) Int. Cl.: H03F 1/02

(54) **Amplificateur à plusieurs étages à faible consommation, et récepteur embarqué de signaux muni d'un tel amplificateur**
Mehrstufiger Verstärker mit geringem Leistungsverbrauch und Bordsignalempfänger mit einem derartigen Vertstärker
Multistage amplifier with low power consumption and onboard signal receiver comprising such an amplifier

(30) Priorité: 24.03.1994 FR 9403457
(43) Date de publication de la demande: 27.09.1995
(73) Titulaire: VALEO ELECTRONIQUE, 94042 Creteil Cédex (FR)
(72) Inventeur: Rydel, Charles, FR-75019 Paris (FR)
(74) Mandataire: Gamonal, Didier

(56) Documents cités:
- EP-A- 0 060 164
- EP-A- 0 549 045
- US-A- 2 926 307
- US-A- 2 943 267

## Description

La présente invention, telle qu'elle est définie dans les revendications concerne un amplificateur à plusieurs étages à faible consommation, ainsi qu'un récepteur muni d'un tel amplificateur, plus particulièrement un récepteur embarqué dans un véhicule automobile. Un tel récepteur permet de réaliser notamment un récepteur de télécommande par exemple pour l'ouverture des portes du véhicule et un récepteur d'ondes d'interrogation par exemple pour réaliser une alarme ultrasonore volumétrique dans un véhicule.

Dans les véhicules modernes, on trouve de plus en plus de charges électriques qui restent alimentées et fonctionnelles, au moins à l'état de veille, même quand l'utilisateur a fermé et inactivé son véhicule. C'est notamment le cas des systèmes d'accès au véhicule, qui permettent de produire l'ouverture du véhicule par une télécommande autorisée, et le cas des systèmes d'alarme à l'aide d'ondes d'interrogation, qui permettent de produire une alarme si un événement prédéterminé est détecté comme l'intrusion non autorisée ou un bris de vitre dans l'habitacle du véhicule.

Ces systèmes sont donc en permanence connectés à la batterie du véhicule, et parfois à des alimentations de secours, en particulier pour combattre les sabotages et les pannes. De ce fait, la consommation de tels dispositifs doit être aussi réduite que possible.

Ils doivent en outre comprendre un montage électronique à très hautes performances car en général les signaux captés sont de très faible amplitude.

Dans la demande de brevet FR 93.03191 du 19 mars 1993, le déposant à déjà proposé un montage constitué autour d'un amplificateur à fréquence intermédiaire à au moins deux étages connectés en série sur l'alimentation électrique et dont les bornes d'entrée sont connectées en cascade. Le document US-A-2 926 307 divulgue également un dispositif de cette nature.

Un tel dispositif donne pleine satisfaction dans la classe de performances visée, particulièrement au niveau de la consommation électrique. Cependant, dans ce montage, le couplage dynamique des deux étages se fait par l'intermédiaire de deux transformateurs.

Or, les transformateurs doivent être adaptés à la fréquence de travail. De plus, ils ont tendance à dériver en température et ils sont volumineux. Enfin, ils sont sensibles à l'environnement électromagnétique qui, dans le véhicule, devient de plus en plus chargé.

Pour porter remède à ces inconvénients de l'état de la technique, la présente invention concerne un amplificateur du type d'un amplificateur utilisé dans un récepteur embarqué, plus particulièrement dans un véhicule automobile, et comportant au moins un premier et un second étages d'amplification comportant des transistors connectés en série de façon à réduire la consommation statique du montage, caractérisé en ce que les réseaux d'entrée des étages sont couplés par des réactances comme des condensateurs.

De cette façon, on atteint les objets de l'invention en ce que l'on conserve les avantages de l'invention de la précédente demande tout en évitant le recours à des transformateurs.

Selon une autre caractéristique de l'invention, les étages de l'amplificateur sont séparés deux à deux au point de vue dynamique, d'une part par un premier condensateur connecté entre leur point de connexion côté collecteur et la masse, et d'autre part par un second condensateur connecté entre leur point de connexion côté base et la masse.

Selon une autre caractéristique de l'invention, les réactances de connexion sont dimensionnées de façon à travailler dans la bande passante de l'amplificateur comme des convertisseurs d'impédance, pour adapter la résistance de sortie de l'étage précédent à l'impédance d'entrée de l'étage suivant.

Selon une autre caractéristique de l'invention, la branche de sortie de l'un au moins des étages de l'amplificateur comporte un circuit de renforcement du gain aux fréquences élevées.

Selon une autre caractéristique de l'invention, le circuit de renforcement du gain aux fréquences élevées est un circuit accordé sur la fréquence de travail de l'amplificateur.

Selon une autre caractéristique de l'invention l'amplificateur comporte au moins un étage monté en adaptateur d'impédance disposé entre deux étages successifs et connecté en série avec eux.

Selon une autre caractéristique de l'invention l'amplificateur comporte un moyen de commande du gain constitué par un transistor connecté entre la borne de sortie de l'amplificateur et une borne d'injection/ extraction de courant disposée sur l'émetteur du transistor du premier étage, et dont la base est connectée à la sortie d'un circuit de commande du gain.

Selon une autre caractéristique de l'invention, le circuit de commande de gain comporte un transistor dont la base est connectée à la sortie de l'amplificateur, et dont le chemin de conduction est connecté à l'entrée d'un circuit détecteur dont la sortie est connectée à la base du transistor de dérivation de courant.

L'invention concerne aussi un récepteur pour système à ondes d'interrogation, comme un système d'alarme à ultrasons embarqué à bord d'un véhicule, caractérisé en ce qu'il comporte un amplificateur qui utilise la structure de l'amplificateur ci-dessus, amplificateur dont l'entrée est connectée par l'intermédiaire d'un filtre passe-bas à un détecteur de l'onde d'interrogation et dont le moyen de commande de gain comporte un port de sortie d'un microcontrôleur qui produit une récurrence de signaux carrés dont le rapport cyclique est une valeur de réglage du gain de l'amplificateur.

L'invention concerne aussi un récepteur pour système d'accès sans clé à un véhicule, caractérisé en ce qu'il comporte un amplificateur du type décrit ci-dessus, amplificateur dont l'entrée est connectée à la sortie d'un mélangeur dont une première entrée est connectée à une antenne de réception et une seconde entrée est connectée à un oscillateur local, et en ce que le moyen de commande de gain comporte un détecteur à diodes.

D'autres caractéristiques et avantages de la présente invention seront mieux compris à l'aide de la description et des Figures annexées à titre d'exemples de réalisation de la présente invention, qui sont :
- la Figure 1 : un schéma d'un mode de réalisation d'un amplificateur selon l'invention ;
- la Figure 2 : un schéma d'une première variante de contrôle du circuit de l'invention, permettant de faire varier le gain en dérivant une portion du courant;
- la Figure 3 : un schéma d'une seconde variante de contrôle du circuit de l'invention ;
- la Figure 4 : un schéma d'un récepteur embarqué selon l'invention dans son application à un récepteur d'ondes ultrasonores;
- la Figure 5 : un schéma d'un amplificateur à fréquence intermédiaire selon l'invention dans son application à un récepteur radiofréquence pour un système d'accès sans clé.

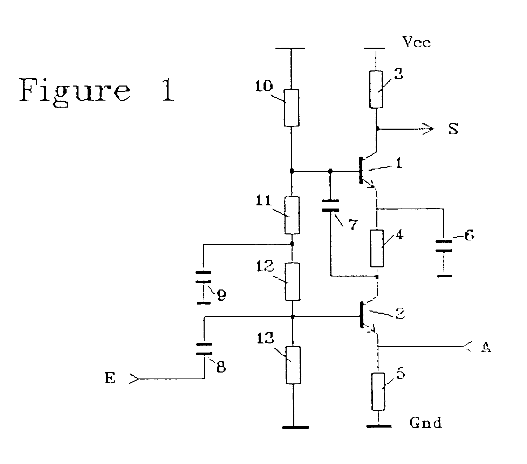

A la Figure 1, on a représenté un amplificateur doté de deux étages 1 et 2 connectés selon le schéma particulier de l'invention.

En effet, au point de vue statique, les étages sont alimentés par une branche résistive, ou pont de polarisation, constituée de résistances 10 - 13, connectées en série entre la tension d'alimentation positive Vcc (trait fin supérieur horizontal) et la masse électrique Gnd de l'amplificateur (trait fort inférieur horizontal).

Le premier étage est constitué par un transistor d'amplification 2, dont la base est connectée au point commun des deux résistances 12, 13 du pont de polarisation 10 - 14, et à une borne d'entrée E à travers un condensateur de liaison 8.

Le second étage est constitué par un transistor d'amplification 1 dont la base est connectée au point commun des deux résistances 10 et 11 du pont de polarisation 10 - 14, et à la sortie du premier étage 2, prise sur le collecteur du transistor 2, a travers une réactance, constituée préférentiellement dans l'invention par un condensateur de liaison 7.

D'une manière générale, dans l'invention la réactance 7 sert de convertisseur, ou d'adaptateur d'impédance entre l'impédance de sortie du premier transistor 2 et l'impédance d'entrée du second transistor 1.

Le point de fonctionnement des étages à transistors 1 et 2 est réglé respectivement par la résistance 3, connectée entre la connexion à la borne positive de l'alimentation Vcc et le collecteur du transistor 1, par la résistance 4, connectée entre l'émetteur du transistor 1 et le collecteur du transistor 2, et enfin par la résistance 5 connectée entre l'émetteur du transistor 2 et la masse Gnd du montage.

Pour séparer les deux étages 1 et 2 au point de vue dynamique, on tire le point de connexion entre les résistances 11 et 12 du pont de polarisation 10 - 13, et le point de connexion entre le collecteur du transistor de sortie du premier étage 2 et la résistance 4, respectivement par des condensateurs 9 et 6, à la masse Gnd du montage.

Le gain de plusieurs étages montés en cascade est égal au produit des gains. De plus, dans un amplificateur comportant des transistors tel que celui de la figure 1, le gain de chaque étage est proportionnel au courant qui le traverse. Or dans cet amplificateur, les courants qui traversent les deux étages sont égaux. Il en résulte que le gain total de l'amplificateur est proportionnel au carré du courant traversant l'amplificateur. Plus généralement, le gain de l'amplificateur est proportionnel à la puissance nième du courant traversant l'amplificateur à n étages.

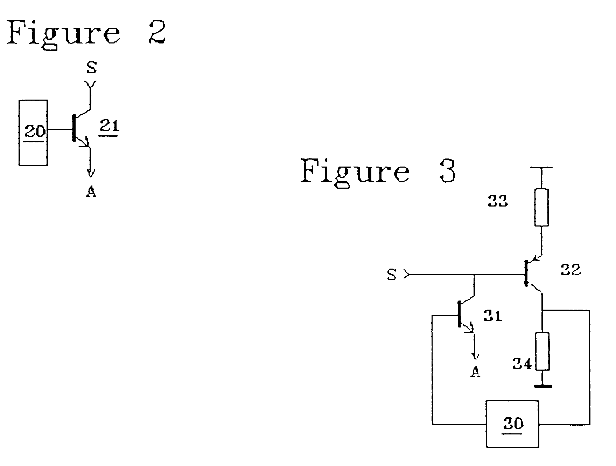

A la Figure 2, on a représenté en relation avec la Figure 1, un schéma d'une première variante d'un moyen de contrôle du circuit de l'invention. Selon cette variante, il est prévu un moyen de commande de la variation du gain de l'amplificateur de l'invention, en dérivant plus ou moins de courant prélevé sur la sortie S du montage de la Figure 1, par un transistor 21 dont le collecteur est connecté à la borne de sortie S et dont l'émetteur est connecté à une borne A de commande de gain du premier étage 2 du montage de la Figure 1, ou borne d'injection de courant.

La base du transistor 21 est commandée par un circuit 20 de réglage du gain qui suit une loi prédéterminée.

De ce fait, si le circuit 20 de réglage de gain tire plus de courant en réduisant l'impédance du transistor 21, le gain du montage, qui dépend du courant traversant les collecteurs des deux étages 1 et 2, se réduit comme le produit des courants traversant chaque étage. On dispose donc d'un moyen efficace et sensible pour commander ou contrôler le gain de l'amplificateur en fonction de tout paramètre de réglage détecté à l'aide du circuit 20 de réglage de gain, dont la sortie commande l'impédance du transistor 21 disposé entre les bornes S et A de l'amplificateur.

A la Figure 3, on a représenté en relation avec la Figure 1, un schéma d'une seconde variante d'un moyen de contrôle du circuit de l'invention. Comme dans le cas de la première variante, un transistor 31 est connecté par son chemin collecteur-émetteur entre la borne de sortie S de l'amplificateur de l'invention (voir Figure 1) et la borne A d'injection de courant sur l'émetteur du transistor du premier étage.

La base du transistor 31 est commandée par un circuit détecteur 30 de valeurs crête, réalisé notamment par un redresseur à diodes, dont l'entrée est connectée sur le collecteur d'un transistor 32 de polarité PNP opposée à la polarité NPN du transistor 31. Le transistor PNP 32 est connecté par son émetteur à la tension positive Vcc d'alimentation du montage, par l'intermédiaire d'une résistance 33, et est connecté par son collecteur à la masse Gnd du montage, par l'intermédiaire d'une résistance 34.

La base du transistor PNP 32 est directement connectée à la borne de sortie S de l'amplificateur de l'invention. Or, du fait de la polarisation, la tension au point S reste constante, puisqu'elle est fixée par la tension V_{BE} du transistor 31. Il en résulte que le circuit détecteur 30 permet de contrôler automatiquement le gain de l'amplificateur en le limitant avant la saturation, et en fonction de la polarisation du transistor 32.

De ce fait, l'amplificateur de l'invention peut travailler avec un fort gain tout en restant dans la zone linéaire de sa caractéristique de fonctionnement et ce sans nécessiter de consommation excessive.

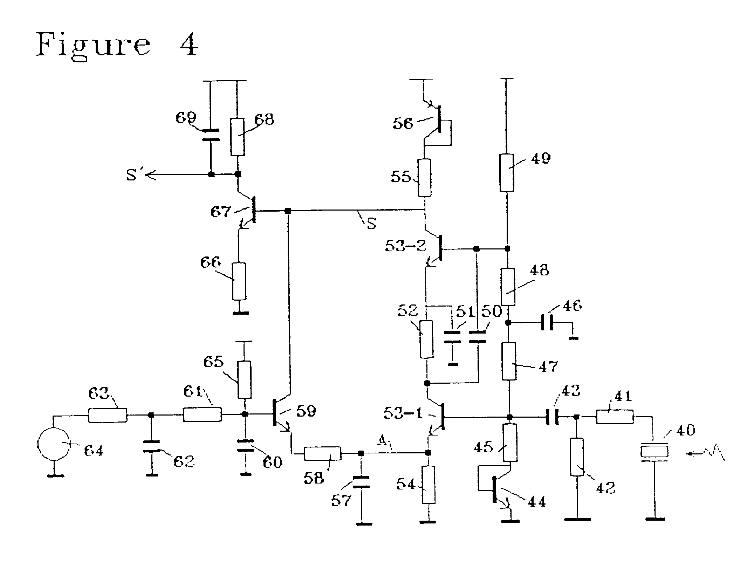

A la Figure 4, on a représenté un schéma d'un mode de réalisation d'un récepteur embarqué selon l'invention dans son application à un récepteur d'ondes d'interrogation. Plus particulièrement, le récepteur est destiné à un système d'alarme à ultrasons volumétrique dans un véhicule, dans lequel le récepteur permet de détecter et d'amplifier les ondes ultrasonores reçues par un capteur piézo-électrique convenable.

A la Figure 4, le capteur 40 d'ondes ultrasonores reçues de l'intérieur de l'habitacle du véhicule surveillé à l'aide du système d'alarme utilisant le récepteur de l'invention est connecté à travers une résistance 41 à un filtre passe haut 42, 43, ici constitué d'une résistance 42 connectée à la masse, et d'un condensateur 43 connecté à l'entrée du premier étage de l'amplificateur de l'invention, qui comporte principalement le pont de polarisation 45, 47 - 49 et les deux étages à transistors 53-1 et 53-2.

On a disposé deux transistors, respectivement, 56 entre le haut de l'amplificateur et la tension d'alimentation positive Vcc, et 44 entre le pied du pont de polarisation et la masse, qui sont tous les deux montés en diode, pour exécuter une compensation des dérives thermiques de l'amplificateur.

L'amplificateur avec ses deux condensateurs 50, de liaison entre étages, et 51 et 46, de liaison à la masse en régime dynamique, ne sera pas décrit plus avant, puisqu'il reprend exactement le montage de la Figure 1.

La sortie S du second étage 53-2 est connectée à un moyen de contrôle du gain selon les deux variantes des Figures 2 et 3, qui ont été combinées ici.

En effet, le transistor 67 est de type NPN et est connecté par sa base à la sortie S, par son émetteur à la masse par l'intermédiaire de la résistance d'émetteur 66 et à la tension positive d'alimentation Vcc par l'intermédiaire d'un circuit série constitué d'une résistance 68 et d'un condensateur 69.

La sortie du récepteur embarqué est prise en S' sur le collecteur du transistor 67. Cette borne de sortie S' est connectée à l'entrée d'un circuit d'analyse non représenté qui produit éventuellement l'action d'alarme.

Le transistor 67 sert à fixer la tension de sortie en S ce qui permet de centrer le gain du montage sur une valeur nominale. Il est donc possible de réaliser un ajustement automatique du gain en fonction d'autres paramètres autour d'une valeur centrale, dans laquelle le récepteur présente un fonctionnement optimal. C'est notamment le cas dans le comportement fréquentiel, dans lequel le gain du récepteur est maximal à la fréquence de récurrence de l'onde d'interrogation, et décroît rapidement pour les fréquences situées de part et d'autre.

Comme le gain du montage est égal au produit des gains des étages, eux mêmes proportionnels au courant traversant leurs collecteurs, si la dynamique de courant de commande est de 10, l'amplificateur produit une dynamique de gain de 100.

Il en résulte que le courant maximum admissible peut être limité à 10 fois le courant minimum fixé notamment par les caractéristiques limite de fonctionnement des transistors.

D'autre part, la commande dynamique du gain est assurée par le transistor 59, dont le chemin collecteur-émetteur est connecté entre la borne S de sortie de l'amplificateur et la borne A d'injection de courant prise comme décrit ci-dessus sur l'émetteur du transistor 53-1 de premier étage. Mais, dans ce mode de réalisation les deux transistors sont connectés par l'intermédiaire d'un filtre passe-bas constitué d'une résistance 58, connectée en série entre l'émetteur du transistor 59 et l'émetteur du transistor 53-1, et d'un condensateur 57, connecté entre l'émetteur du transistor 53-1 et la masse du montage. La commande du transistor 59 est exécutée par sa base, connectée par l'intermédiaire d'un filtre passe-bas, ici constitué de deux cellules d'ordre 1 63, 62 et 61, 60. Le transistor 59 est polarisé par l'intermédiaire de la résistance 65 et de son filtre passe-bas d'entrée.

La filtre passe-bas 60 - 63 est connecté à un port de sortie 64 d'un microcontrôleur (non représenté) qui produit une récurrence de signaux carrés, dont le rapport cyclique représente la valeur de consigne de réglage du gain de l'amplificateur. En effet, un tel circuit de commande polarise plus ou moins le transistor 59 et commande donc son impédance de façon à lui faire dériver plus ou moins de courant dans les collecteurs des deux étages de l'amplificateur, selon le mécanisme décrit précédemment.

Dans une mise en pratique de l'invention, appliquée à un système d'alarme à ultrasons, le port de sortie 64 du microcontrôleur a une résolution de 8 bits et produisait une résolution meilleure que 2 dB avec une précision de réglage de +/- 5% sur le réglage du rapport cyclique.

On remarque que dans ce montage, la consommation peut être aussi réduite que 300 microampères avec une bande passante centrée sur 40 kHz, et une plage de réglage linéaire du gain sur 50 dB, en travaillant sous une tension Vcc de 5 volts. Un seul port de sortie du microcontrôleur est occupé, ce qui permet facilement de multiplier les récepteurs pour surveiller plusieurs zones en permanence.

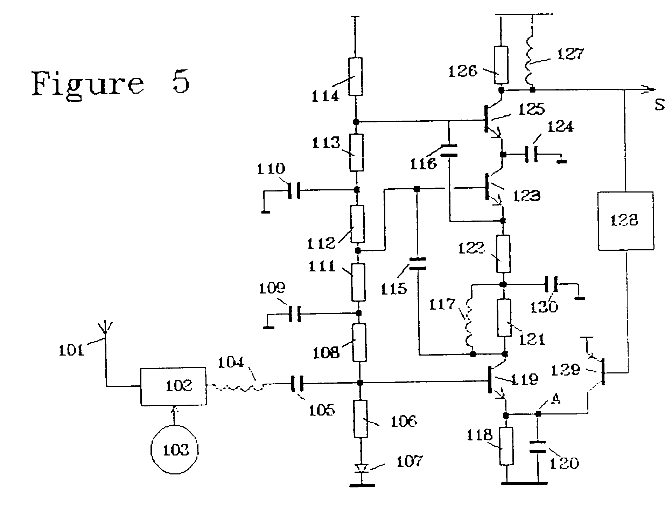

A la Figure 5, on a représenté un schéma d'un récepteur embarqué selon l'invention dans son application à un récepteur radiofréquence pour un système d'accès sans clé.

Dans le mode de réalisation de la Figure 5, l'amplificateur de l'invention comporte trois étages selon le montage de l'invention.

L'antenne 101 du système d'accès sans clé au véhicule à bord duquel est embarqué le récepteur décrit est connectée directement ou par un condensateur de découplage, et éventuellement par un câble de liaison adapté à la première entrée d'un mélangeur 102. La seconde entrée du mélangeur 102 est connectée à l'entrée d'un oscillateur local 103 qui produit une onde dont la fréquence caractéristique est centrée sur la porteuse de l'onde modulée reçue par l'antenne 101. La sortie du mélangeur 102 produit ainsi un signal d'entrée dit à fréquence intermédiaire, constitué par le battement de l'onde modulée et de l'onde de l'oscillateur local 103, qui est transmis à la base d'un transistor 119 à titre de premier étage de l'amplificateur monté selon les enseignements de l'invention, par l'intermédiaire d'une inductance 104, qui sert à compenser la capacité d'entrée C_{BE} du premier étage de l'amplificateur à fréquence intermédiaire.

L'amplificateur du récepteur de la Figure 5 est ici un amplificateur à fréquence intermédiaire et comporte trois étages d'amplification, respectivement 119, 123 et 125, qui sont connectés en série au point de vue des polarisations, obtenues par le pont de polarisation 106 - 108, 111 - 114, et en cascade au point de vue dynamique, par les connexions par la réactance 115, disposée entre la sortie du premier étage 119 et l'entrée du second étage 123, et par la réactance 116, disposée entre la sortie du second étage 123 et l'entrée du troisième étage 125. Les étages sont séparés en dynamique comme précédemment décrit pas les condensateurs 124 et 130 entre les trois étages et 109 , 110 entre les trois portions concernées du pont de polarisation.

L'émetteur du transistor 119 de premier étage est connecté à la masse par l'intermédiaire d'une résistance 118 en parallèle avec un condensateur de découplage d'émetteur 120. Le collecteur du transistor de premier étage 119 est chargé par l'intermédiaire d'un circuit constitué d'une résistance 121 et d'une inductance 117, qui sert à augmenter le gain aux fréquences élevées et la tension Collecteur/Emetteur.

Le second étage 122 est disposé en étage collecteur commun et a pour but de permettre l'adaptation d'impédance entre le premier étage 119 et le second étage 125.

Le collecteur du transistor 125 de troisième étage est connecté à la tension positive d'alimentation par l'intermédiaire d'un circuit constitué d'une résistance 126 et d'une inductance 127 qui sert à augmenter le gain aux fréquences élevées ainsi que la dynamique d'excursion de sortie.

Les deux circuits de relèvement de gain à hautes fréquences peuvent l'un ou l'autre, ou l'un et l'autre, être remplacé par des circuits accordés sur la fréquence intermédiaire pour augmenter le rendement de l'amplificateur.

La sortie S de l'amplificateur est connectée par l'intermédiaire d'un circuit de commande de gain 128 à la base d'un transistor 129 d'injection ou de prélèvement de courant pour contrôler le gain de l'amplificateur ainsi qu'il a été précédemment exposé.

Dans le cas d'un récepteur de signal de télécommande radiofréquence en modulation angulaire, le circuit de commande 128 est constitué par un détecteur à diodes.

## Revendications

1. Amplificateur du type d'un amplificateur utilisé dans un récepteur embarqué, plus particulièrement dans un véhicule automobile, et comportant au moins un premier (2) et un second (1) étages d'amplification comportant des transistors dans lequel les réseaux de polarisation (10 - 13) des étages sont connectés en série de façon à réduire la consommation statique du montage, caractérisé en ce que les réseaux d'entrée des étages sont couplés par des réactances comme des condensateurs (7), et en ce qu'il comporte un moyen de commande du gain constitué par un transistor (21 ; 31) de dérivation de courant connecté entre la borne de sortie (S) de l'amplificateur et une borne (A) d'injection/ extraction de courant disposée sur l'émetteur du transistor (2) du premier étage, et dont la base est connectée à la sortie d'un circuit de commande (20 ; 31, 32 - 34) du gain.

2. Amplificateur selon la revendication 1, caractérisé en ce que les étages (1, 2) de l'amplificateur sont séparés deux à deux au point de vue dynamique, d'une part par un premier condensateur (6) connecté entre leur point de connexion côté collecteur et la masse (Gnd), et d'autre part par un second condensateur (9) connecté entre leur point de connexion côté base et la masse (Gnd).

3. Amplificateur selon la revendication 1, caractérisé en ce que les réactances de connexion (7 ; 115, 116) sont dimensionnées de façon à travailler dans la bande passante de l'amplificateur comme des convertisseurs d'impédance, pour adapter la résistance de sortie de l'étage précédent à l'impédance d'entrée de l'étage suivant.

4. Amplificateur selon la revendication 1, caractérisé en ce que la branche de sortie de l'un au moins des étages de l'amplificateur comporte un circuit (117, 121 ; 126, 127) de renforcement du gain aux fréquences élevées.

5. Amplificateur selon la revendication 4, caractérisé en ce que le circuit (117, 121 ; 126, 127) de renforcement du gain aux fréquences élevées est un circuit accordé sur la fréquence de travail de l'amplificateur.

6. Amplificateur selon la revendication 1, caractérisé en ce qu'il comporte au moins un étage (123) monté en adaptateur d'impédance disposé entre deux étages successifs (119 ; 125) et connecté en série avec eux.

7. Amplificateur selon la revendication 1, caractérisé en ce que le circuit de commande de gain comporte un transistor (32) dont la base est connectée à la sortie (S) de l'amplificateur, et dont le chemin de conduction est connecté à l'entrée d'un circuit détecteur (30) dont la sortie est connectée à la base du transistor de dérivation de courant (31).

8. Récepteur pour système à ondes d'interrogation, comme un système d'alarme à ultrasons embarqués à bord d'un véhicule, caractérisé en ce qu'il comporte un amplificateur selon l'une des revendications 1 à 7, amplificateur dont l'entrée est connectée par l'intermédiaire d'un filtre passe-bas à un détecteur (40) de l'onde d'interrogation et dont le moyen de commande de gain comporte un port de sortie (64) d'un microcontrôleur qui produit une récurrence de signaux carrés dont le rapport cyclique est une valeur de réglage du gain de l'amplificateur.

9. Récepteur pour système d'accès sans clé à un véhicule, caractérisé en ce qu'il comporte un amplificateur selon l'une des revendications 1 à 7, amplificateur dont l'entrée est connectée à la sortie d'un mélangeur (102) dont une première entrée est connectée à une antenne (101) de réception et une seconde entrée est connectée à un oscillateur local (103), et en ce que le moyen de commande de gain comporte un détecteur à diodes (128).

## Patentansprüche

1. Verstärker des Typs eines Verstärkers, der in einem Bordempfänger, insbesonders in einem Kraftfahrzeug, verwendet wird und mindestens eine erste (2) und eine zweite (1) Verstärkungsstufe enthält, die Transistoren umfassen, wobei die Vorspannungnetze (10 - 13) der Stufen in Reihe geschaltet sind, um den statischen Leistungsverbrauch der Schaltung zu verringern, **dadurch gekennzeichnet**, daß die Eingangsnetze der Stufen durch Reaktanzen wie Kondensatoren (7) gekoppelt sind und daß er ein Steuerungsmittel für den Verstärkungsfaktor umfaßt, das aus einem Stromabzweigungstransistor (21; 31) besteht, der zwischen der Ausgangsklemme (S) des Verstärkers und einer Stromeinspeisungs-/Stromentnahmeklemme (A) angeschlossen ist, die am Emitter des Transistors (2) der ersten Stufe angeordnet ist, und dessen Basis an den Ausgang einer Steuerschaltung (20; 31, 32 - 34) für den Verstärkungsfaktor angeschlossen ist.

2. Verstärker nach Anspruch 1 , **dadurch gekennzeichnet**, daß die Stufen (1, 2) des Verstärkers in dynamischer Hinsicht paarweise einerseits durch einen ersten Kondensator (6), der zwischen ihrem kollektorseitigen Anschlußpunkt und der Masse (Gnd) geschaltet ist, und andererseits durch einen zweiten Kondensator (9) getrennt sind, der zwischen ihrem basisseitigen Anschlußpunkt und der Masse (Gnd) geschaltet ist.

3. Verstärker nach Anspruch 1 , **dadurch gekennzeichnet**, daß die Anschlußreaktanzen (7; 115, 116) so ausgelegt sind, daß sie im Durchlaßband des Verstärkers als Impedanzwandler arbeiten, um den Ausgangswiderstand der vorangehenden Stufe an die Eingangsimpedanz der nachfolgenden Stufe anzupassen.

4. Verstärker nach Anspruch 1 , **dadurch gekennzeichnet**, daß der Ausgangsstrang mindestens einer der Stufen des Verstärkers eine Schaltung (117, 121; 126, 127) zur Steigerung des Verstärkungsfaktors bei hohen Frequenzen umfaßt.

5. Verstärker nach Anspruch 4 , **dadurch gekennzeichnet**, daß die Schaltung (117, 121; 126, 127) zur Steigerung des Verstärkungsfaktors bei hohen Frequenzen eine auf die Arbeitsfrequenz des Verstärkers abgestimmte Schaltung ist.

6. Verstärker nach Anspruch 1 , **dadurch gekennzeichnet**, daß er mindestens eine als Impedanzanpasser geschaltete Stufe (123) umfaßt, die zwischen zwei aufeinanderfolgenden Stufen (119; 125) angeordnet und mit diesen in Reihe geschaltet ist.

7. Verstärker nach Anspruch 1 , **dadurch gekennzeichnet**, daß die Steuerschaltung für den Verstärkungsfaktor einen Transistor (32) umfaßt, dessen Basis an den Ausgang (S) des Verstärkers angeschlossen ist und dessen Leitungsbahn an den Eingang einer Erfassungsschaltung (30) angeschlossen ist, deren Ausgang an die Basis des Stromabzweigungstransistors (31) angeschlossen ist.

8. Empfänger für ein Abfragewellensystem, wie eine an Bord eines Fahrzeugs installierte Ultraschall-Alarmanlage , **dadurch gekennzeichnet**, daß er einen Verstärker nach einem der Ansprüche 1 bis 7 umfaßt, wobei der Eingang des Verstärkers über ein Tiefpaßfilter an einen Abfragewellendetektor (40) angeschlossen ist und sein Mittel zur Steuerung des Verstärkungsfaktors einen Ausgangsport (64) eines Mikrosteuerbausteins umfaßt, der eine Folge von Rechtecksignalen erzeugt, deren Tastverhältnis ein Einstellwert für den Verstärkungsfaktor des Verstärkers ist.

9. Empfänger für ein schlüsselloses Zugangssystem zu einem Fahrzeug, **dadurch gekennzeichnet**, daß er einen Verstärker nach einem der Ansprüche 1 bis 7 umfaßt, wobei der Eingang des Verstärkers an den Ausgang eines Mischers (102) angeschlossen ist, dessen erster Eingang an eine Empfangsantenne (101) angeschlossen ist und dessen zweiter Eingang an einen Lokaloszillator (103) angeschlossen ist, und daß das Mittel zur Steuerung des Verstärkungsfaktors einen Diodendetektor (128) umfaßt.

## Claims

1. An amplifier, of the type of amplifier used in an onboard receiver, more particularly in a motor vehicle, having at least one first amplifier stage (2) and a second amplifier stage (1), comprising transistors in which the polarisation networks (10 - 13) for the stages are connected in series in such a way as to reduce the static power consumption of the circuitry, characterised in that the input networks of the stages are coupled through reactances such as capacitors (7), and in that it includes a gain control means comprising a current take-off transistor (21; 31) connected between the output terminal (S) of the amplifier and a terminal (A) for injection or extraction of current, which is disposed on the emitter of the transistor (2) of the first stage, the base thereof being connected to the output of a gain control circuit (20; 31, 32 -34).

2. An amplifier according to Claim 1, characterised in that the stages (1, 2) of the amplifier are separated one from another in the dynamic state, firstly by a first capacitor (6) connected between their point of connection on the collector side and earth (Gnd), and secondly through a second capacitor (9) which is connected between their point of connection on the base side and earth (Gnd).

3. An amplifier according to Claim 1, characterised in that the connecting reactances (7; 115, 116) are so dimensioned as to work in the pass band of the amplifier as impedance converters, so as to match the output resistance of the preceding stage to the input impedance of the next following stage.

4. An amplifier according to Claim 1, characterised in that the output branch of at least one of the stages of the amplifier comprises a circuit (117, 121; 126, 127) for reinforcing the gain at high frequencies.

5. An amplifier according to Claim 4, characterised in that the circuit (117, 121; 126, 127) for reinforcing the gain at high frequencies is a circuit tuned to the working frequency of the amplifier.

6. An amplifier according to Claim 1, characterised in that it includes at least one stage (123) connected for impedance matching and disposed between two successive stages (119; 125), with which it is connected in series.

7. An amplifier according to Claim 1, characterised in that the gain control circuit includes a transistor (32), the base of which is connected to the output (S) of the amplifier, with its conduction path being connected to the input of a detector circuit (30), the output of which is connected to the base of the current take-off transistor (31).

8. A receiver for an interrogation wave system such as an ultrasonic alarm system carried on board a vehicle, characterised in that it comprises an amplifier in accordance with any one of Claims 1 to 7, with the input of the amplifier being connected through a low pass filter to a detector (40) for detecting the interrogation wave, its gain control means comprising an output stage (64) of a microcontroller which produces a series of recurring square wave signals having a cyclic ratio which is an adjustment value for the gain of the amplifier.

9. A receiver for a keyless system for giving access to a vehicle, characterised in that it comprises an amplifier according to one of Claims 1 to 7, the input of the amplifier being connected to the output of a mixer (102), which has a first input connected to a receiving antenna (101) and a second input connected to a local oscillator (103), and in that the gain control means comprises a diode-type detector (128).
